# EUROPEAN PATENT SPECIFICATION

(11) **EP 2 742 016 B1**
(45) Date of publication and mention of the grant of the patent: **02.10.2019**
(21) Application number: 12768735.8
(22) Date of filing: 08.08.2012
(51) Int. Cl.: C03C 27/00, C04B 35/634, H01L 21/687, C04B 37/00, C04B 37/04

(54) **METHOD FOR JOINING COMPONENTS AND HOLDING DEVICE FOR A WAFER**
VERFAHREN ZUM VERBINDEN VON KOMPONENTEN UND HALTEVORRICHTUNG FÜR EINEN WAFER
PROCÉDÉ POUR JOINDRE DES COMPOSANTS ET DISPOSITIF DE MAINTIEN POUR UNE PLAQUETTE

(30) Priority: 09.08.2011 DE 102011080635; 09.08.2011 US 201161521564 P
(43) Date of publication of application: 18.06.2014
(73) Proprietor: Carl Zeiss SMT GmbH, 73447 Oberkochen (DE)
(72) Inventor: CHUNG, Hin Yiu Anthony, 89075 Ulm (DE); DOCHNAHL, Axel, 73494 Rosenberg (DE); STAMPE, Tim, 14129 Berlin (DE); PETZOLD, Werner, 89547 Gerstetten (DE); REIMANN, Bernd, 73430 Aalen (DE)
(74) Representative: Kohler Schmid Möbus Patentanwälte
(86) International application number: PCT/EP2012/065521
(87) International publication number: WO 2013/021007

(56) References cited:
- EP-A2- 0 244 993
- WO-A2-2008/017449
- WO-A2-2009/106305
- US-A1- 2005 072 189

## Description

### Background of the invention

The invention relates to a method for joining two components having different stiffnesses, and to a holding device for a wafer.

For mounting plate-like objects in the form of wafers, so-called wafer chucks are used, which are intended to suitably position or fix the wafer. In this case, the wafer itself is typically mounted on a likewise plate-shaped mount, which is designated as a wafer table. In order to manipulate the wafer, the latter together with the wafer table is fixed on the top side of the wafer chuck, or connected to the wafer chuck.

A plurality of methods for connecting two bodies have been disclosed for example by WO 2008/017449 A2 from the applicant. In order to connect two or more bodies or components, it is known, for example, to wring the two components onto one another. Wringing is a connection of two materials in which the surfaces brought together are held only by forces of molecular attraction, and so the connection (for example under the influence of moisture or the wedge effect) can be partly or completely detached. However, wringing is not possible for all materials or material combinations, the size of the surfaces that are intended to be wrung onto one another also being of importance. In order to obtain a connection between components which can be wrung only with difficulty, it is possible for the two components to be directly bonded to one another.

When adhesively bonding components, however, the problem occurs that the adhesive used cures, as a result of which the adhesive is subject to shrinkage.

Stresses can occur on the components as a result, said stresses resulting in deformations. This may be problematic if the components adhesively bonded to one another have (greatly) different stiffnesses, since in this case the deformations caused by the adhesive bonding are largely transferred to the less stiff component.

Such transfer to the less stiff component is unfavorable particularly for the case where this component is intended to have the highest possible dimensional stability. This is the case e.g. when adhesively bonding a "wafer table", which generally consists of a material having greater stiffness to the "wafer chuck", which typically has a lower stiffness. The "wafer chuck" typically has on at least one side surface a mirror or a mirroring coating for determining the position of the "wafer chuck" by means of a laser and should therefore have a high dimensional stability.

The wafer chuck is typically formed from a comparatively light material in order to reduce the inertia during movement or during positioning, and can be produced e.g. wholly or partly from Zerodur® or from cordierite, which have a low relative density and a low stiffness. The deformations caused by the shrinkage of the adhesive can therefore lead to inaccurate positioning and thus to possibly drastic faults in the overlay (in the case of a plurality of successive exposures) and may possibly render the "wafer chuck" unusable for use in microlithography.

US 2005/0072189 A1 describes anodic bonding of silicon carbide to glass to fabricate a MEMS device.

EP 0244 993 A2 discloses a laminated ceramic structure having a facing member and a backing member which are bonded together either directly or through an intermediate layer. In one example, a SiC faceplate and a B₄C backplate are assembled on either side of a fiber-reinforced glass layer, and this assembly is hot-pressed to form the laminated ceramic structure.

WO 2008/017449 A2 discloses a composite structure for microlithography, e.g. a holding device for a wafer. In one example, two components of the composite structure are bonded by means of a glass film (glass frit).

WO 2009/106305 A2 discloses a method of bonding two components by "fusion bonding" to form a bonded structure, e.g. a holding device for a wafer.

### Object of the invention

It is an object of the invention to provide a method for joining components having different stiffnesses in a manner exhibiting low deformation.

### Subject matter of the invention

This object is achieved by means of a method for joining two components having different stiffnesses to form a holding device for a wafer, comprising: bonding a plate-shaped body onto the component having greater stiffness, the bonding being performed using an adhesive, correcting deformations produced by the bonding on the plate-shaped body, and joining the component having the lower stiffness to the plate-shaped body without using a joining agent.

The invention proposes bonding a plate-shaped body to the component having greater stiffness. In this case, the plate-shaped body can have a lower stiffness than the first component, such that the mechanical stresses or deformations caused by the bonding, e.g. in the case of adhesive bonding, adhesive curing or the adhesive slippage are transferred to the plate-shaped body. The resultant deformations on the plate-shaped body are corrected, e.g. by smoothing the surface at which the second component is connected to the plate-shaped body.

In one variant, the component having the lower stiffness is joined to the plate-shaped body by wringing, by anodic bonding or by fusion bonding. Since no or only very small additional deformations are produced in the components by the wringing or bonding, a joining method exhibiting low deformation can be realized in the manner described above. This is possible since the joining methods described above manage without the use of a joining agent ("direct bond"). In "fusion bonding", upon reaching or exceeding the transition temperature of the glass phase, the surfaces to be connected are incipiently melted and, in so-called anodic bonding, charge transport promotes a chemical reaction of the materials to be connected in the region of the surfaces, such that anodic bonding can be carried out at lower temperatures than "fusion bonding". In anodic bonding, it may be of advantage for a generally metallic coating to be applied to at least one of the surfaces to be connected.

By contrast, a connection which arises using a joining agent is generally not suitable for connection in a manner exhibiting low deformation. Thus, for the connection of two components containing silicon, it is known from US 6,284,085 B1 to perform the connection by means of hydroxide-catalyzed hydration/dehydration at room temperature by applying hydroxide ions to at least one of the surfaces to be joined before the surfaces are brought together sufficiently closely that a chemical (covalent) bond forms between them. US 2004/0247826 A1 has furthermore disclosed a method for producing composite structures, wherein the connection between two components is produced by the curing of a silicate-containing joining agent at room temperature or by thermal treatment with a predefined, slow temperature increase for dehydrating the connection. Although both methods can also be used, in principle, for connecting the component having the higher stiffness and the plate-shaped body, the deformation produced in this case or the drift in the deformation may be too great for the present applications, so that adhesive bonding of the component having the greater stiffness to the plate-shaped body is preferred.

In the present case, the stiffness of the bodies is understood to mean the (material-specific) modulus of elasticity of the components (e.g. in N/mm²). In the present case, a plate-shaped body is understood to mean a body whose thickness is 10 mm or less, typical values generally being approximately 5 mm or less. In order to facilitate the connection to a silicon-containing component, it is advantageous if the plate-shaped body itself contains silicon and is formed e.g. from quartz glass.

In one development, the wringing is preceded by a cleaning step and/or the wringing is supported by means of a liquid. For the wringing, the components to be joined should be as free of particles as possible, which can be achieved by means of surface cleaning, which can comprise cleaning methods such as cleaning with acetone or rubbing with buckskin. The wringing can, if appropriate, be supported by a liquid applied to one or both surfaces directly before the wringing. By way of example, polydimethylsiloxane has proved to be suitable as a liquid which promotes wringing. Wringable materials are e.g. quartz glass, ULE® or Zerodur®.

In one variant, the plate-shaped body consists of glass, in particular of quartz glass, and the body is preferably subjected to heat treatment after bonding in order to reduce mechanical stresses and in order to increase the mechanical stability. The use of a thin glass plate which is bonded onto the first component has proved to be particularly advantageous for taking up the mechanical stresses, since the mechanical stresses transmitted thereto can be successfully reduced or compensated for, e.g. by heat treatment and/or by postprocessing. In a further variant, before correcting the deformations on the plate-like body there is a wait until the mechanical stresses produced on the plate-shaped body by the bonding (practically) no longer change. In this way it is possible to avoid a situation in which stresses still present in the body after the correction step can once again result in deformations and, if appropriate, after the wringing or bonding, can result in undesirable deformations which can have the consequence of destabilizing the connection at the respective surfaces.

In one variant, there is a wait lasting for at least one week, preferably at least three weeks, between bonding the plate-like body and correcting the deformations on the plate-shaped body. The composite composed of the component having the higher stiffness and the plate-shaped body is stored for at least one week, wherein, depending on the thickness and material of the plate-shaped body, storage over three or more weeks may also be of advantage. The long storage makes it possible to ensure that the mechanical stresses in the plate-shaped body have undergone transition to an equilibrium state and (practically) no longer change when the corrections are performed.

In one variant, correcting comprises smoothing a surface of the plate-shaped body to which the second component is connected. The stresses in the plate-shaped body result in deformations, which in particular also occur at that surface of the plate-shaped body at which the second component is intended to be connected to the plate-shaped body. The deformations at said surface can be corrected by smoothing, wherein smoothing can comprise one or more mechanical polishing steps. Additionally or alternatively, the surface can also be smoothed by ion beam processing. In both cases, the smoothing can be carried out until a virtually perfect surface flatness has been achieved, which facilitates wringing or bonding of the component having the lower stiffness.

In a further variant, the component having the greater stiffness contains silicon carbide, and in particular is formed from SiSiC, at least in the region of the connection to the plate-shaped body. SiSiC is reaction-bonded silicon-infiltrated silicon carbide. The latter consists of a high proportion of silicon carbide (generally > 85 %) and a correspondingly lower proportion of metallic silicon (generally < 15 %) and has practically no residual porosity owing to the manner in which it is produced. Such a material, which furthermore has a high hardness and stiffness (of approximately 400000 N/mm²), is particularly suitable for serving as a support for a wafer or as a wafer table or as a carrier with a cooling function.

In a further variant, the component having the lower stiffness is formed from cordierite, a glass ceramic, quartz glass or a doped silicate glass, at least in the region of the connection to the plate-shaped body. Cordierite has also proved to be suitable material for a wafer chuck, in particular on account of its low relative density. Glass ceramics and doped silicate glass have also proved to be of advantage on account of the low coefficient of thermal expansion in particular for use as a wafer chuck or as substrates for EUV mirrors, but have a significantly lower stiffness in comparison with materials such as silicon carbide, the structure and the typically smaller thickness of the second component also being of importance for the transfer of the deformations initiated by the adhesive shrinkage. If appropriate, a coating can also be provided at the surface of the less stiff component which is connected to the plate-shaped body, in order to facilitate the connection to the plate-shaped body. By way of example, in the case of anodic bonding, a metallic coating, e.g. composed of aluminum, can be provided on the less stiff component.

Glass ceramics typically consist of silicon dioxide, with which oxides of various other materials such as e.g. lithium (Li), magnesium (Mg) or aluminum (Al) are admixed. The ratio of the crystal phase to the glass phase in such a ceramic is generally set such that the coefficients of thermal expansion of the different phases virtually cancel one another out near the so-called zero crossing temperature, such that these materials in the operating temperature range are likewise distinguished by an extremely low thermal expansion. Such glass ceramics are offered e.g. by Schott AG under the trade names Zerodur® or by Ohara Inc. under the trade name Clearceram®.

A further group of materials that satisfies the requirements in respect of a low coefficient of thermal expansion is doped silicate glasses, e.g. silicate or quartz glass doped with titanium dioxide, which typically has a silicate glass proportion of more than 90%. One such silicate glass that is commercially available is sold by Corning Inc. under the trade name ULE® (Ultra Low Expansion Glass). In this material, the ratio of the titanium dioxide proportion to the silicate glass proportion is chosen during production such that the coefficients of thermal expansion of the two proportions approximately compensate for one another.

A further aspect of the invention relates to a holding device for a wafer, comprising: a first and second component having different stiffnesses, and a plate-shaped body bonded onto the component having the greater stiffness using an adhesive, wherein the component having the lower stiffness is connected to a surface of the plate-shaped body which faces away from the component having the greater stiffness, without using a joining agent. During the formation of such a holding device, only few deformations are produced in the component having the lower stiffness, since the deformations produced during bonding were taken up by the plate-shaped body before the component having the lower stiffness is connected to the processed, smooth surface of the plate-shaped body.

In one embodiment, the plate-shaped body is a glass plate, which typically has a thickness of less than approximately 10 mm. This is of advantage in order that mechanical stresses produced in the glass plate can be reduced comparatively rapidly. Moreover, the provision of a comparatively thin plate means that the volume and weight of the composite body are not increased unnecessarily.

In one embodiment, the stiffness of the component having the greater stiffness is at least double, if appropriate at least four times, the magnitude of the stiffness of the component having the lower stiffness. This is the case for two components, for example, in which the material having the greater stiffness (at least in the region of the connection to the plate-shaped body), consists of silicon carbide or SiSiC and the material having the lower stiffness consists of cordierite, a glass ceramic, a doped silicate glass or quartz glass.

As explained above, the composite structure can serve as a holding device for a wafer particularly when the materials specified above are used. In this case, the component having the higher stiffness serves for (directly) supporting the wafer (wafer table). The component having the lower stiffness serves for positioning the component having the higher stiffness and preferably has one or more mirrors for this purpose. The mirrors can be formed e.g. laterally on the component having the lower stiffness and can serve for reflecting laser radiation or the like. In particular, reflective multilayer coatings can also be used as mirrors, but it is also possible, if appropriate, to use a mirror composed of a single material, e.g. an aluminum plate.

In an example not in accordance with the invention, the component having the lower stiffness has a coating which is reflective to EUV radiation. In this case, the body having the lower stiffness is embodied as an EUV mirror having a substrate composed of Zerodur® or composed of ULE®, for example, to which the coating which is reflective to EUV radiation is applied. The EUV mirror is connected by its surface facing away from the coating to the plate-shaped body or to the component having the greater stiffness, which forms a carrier for the EUV mirror in order to increase the mechanical stability thereof or in order to cool the mirror. If the carrier is intended to fulfill a cooling function, one or more cooling channels are generally provided in it.

It goes without saying that the above description of a composite body was given for two components, but that three or more components each having a different stiffness can also be connected to one another in the manner described above.

Further features and advantages of the invention are evident from the following description of exemplary embodiments of the invention, with reference to the figures of the drawing showing details essential to the invention and from the claims. The individual features can be realized in each case individually by themselves or as a plurality in any desired combination in a variant of the invention.

### Drawing

Exemplary embodiments are illustrated in the schematic drawing and are explained in the description below. In the figures:
- **Figure 1**: shows a schematic illustration of a method for bonding two components by adhesive bonding, and
- **Figures 2a,b**: show schematic illustrations of a method for joining two components using a glass plate for taking up deformations, and
- **Figures 3a,b**: show schematic illustrations of a method analogously to Figures 2a,b, not in accordance with the invention, wherein an EUV mirror is connected to a carrier.

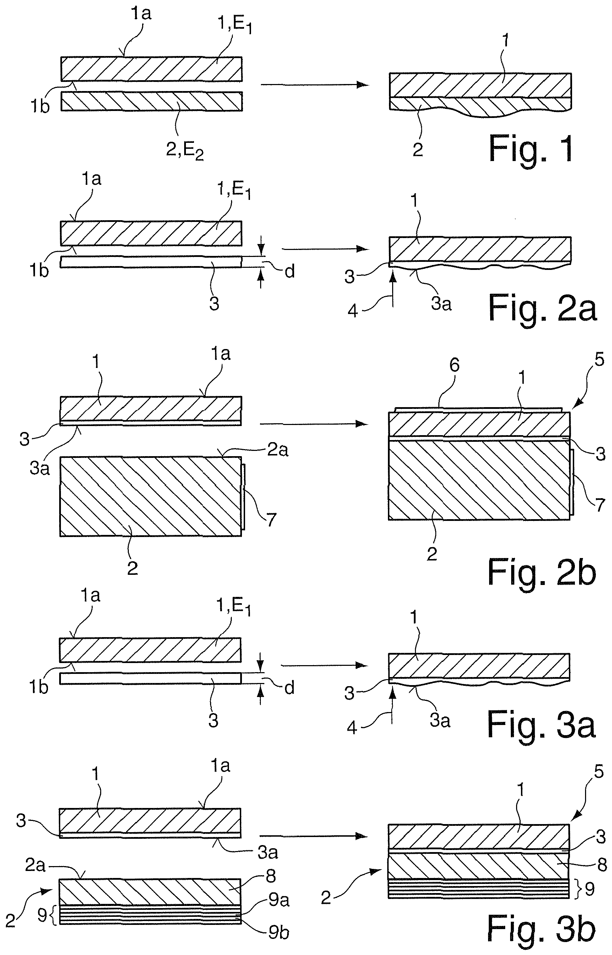

**Figure 1** schematically shows a method for connecting two components 1, 2 by adhesive bonding. In the present example, the first component 1 is formed from SiSiC and has a stiffness E1 (modulus of elasticity) of approximately 400000 N/mm². In the present example, the second component 2 consists of Zerodur® having a stiffness E2 of 90000 N/mm². The first component 1 forms a so-called "wafer table", and the second component 2 forms a "wafer chuck" for a wafer (not shown in Figure 1) that is placed onto the top side 1a of the first component 1. It goes without saying that other materials can also be used for the first and second components 1, 2; by way of example, the first component 1 can consist of silicon carbide and the second component 2 can consist of a glass ceramic or a doped quartz glass or of cordierite, having a low coefficient of thermal expansion (CTE).

The first and/or the second component 1, 2 can if appropriate itself/themselves form a composite structure composed of a plurality of different materials. By way of example, the second component 2 can consist of Zerodur® in a volume region facing the first component 1 and can consist of a different material having a low coefficient of thermal expansion, for example of cordierite, in a volume region facing away from the first component 1.

In the method shown in Figure 1, the first component 1 is connected to the second component 2 by adhesive bonding. The choice of the adhesive (not shown) is dependent, in particular, on the type of material of the first component 1. Suitable adhesives are typically 2-component adhesives, more particularly epoxy adhesives, and 1-component adhesives, possibly in the form of UV-curable adhesives. Since such an adhesive generally shrinks after adhesive bonding, local deformations or stresses occur between the two components 1, 2, which are essentially transferred to the second component 2 on account of the lower stiffness E2 < E1. The deformations on the second component 2 are illustrated (in a greatly exaggerated manner) on the right-hand side in Figure 1.

In order to connect the two components 1, 2 to one another without appreciable deformations of the second component 2 occurring, a method is used which is described in greater detail below with reference to Figures 2a,b. In the method, firstly a first step involves adhesively bonding a plate-shaped body in the form of a thin glass plate 3 having a thickness d of typically a few millimeters (e.g. 10 mm or less) onto a surface 1b of the first component 1. Since, in the present example, the glass plate 3 has a stiffness that is lower than the stiffness E1 of the first component 1, the deformations caused during adhesive bonding are essentially transferred into the glass plate 3, as is illustrated on the right-hand side in Figure 2a. It will be appreciated that similar deformations may be caused when the bonding of the plate-shaped body 3 to the surface 1b of the first component 1 is performed e.g. using a hydration/dehydration process as disclosed in US 6,284,085 B1 or when a joining agent is used for the bonding, as described e.g. in US 2004/0247826 A1.

In order to reduce the mechanical deformations in the glass plate 3, the glass plate 3 is firstly subjected to heat treatment, i.e. heated to a temperature of approximately 60°C, and kept at this temperature over a period of several hours in order to compensate for the deformations. Afterward, the component 1 with the adhesively bonded glass plate 3 is stored over a longer period (typically for at least one week, if appropriate three weeks or more), until the stresses caused by the adhesive shrinkage in the glass plate 3 and thus the deformations at the surface 3a of the glass plate 3 are temporally stable.

A subsequent step involves correcting the deformations of the glass plate 3 by smoothing the surface 3a of the glass plate 3 facing away from the first component 1, to be precise in the present example by processing using an ion beam 4 ("ion beam figuring"), which is moved in a scanning fashion over the surface 3a. It goes without saying that alternatively or additionally it is also possible to use other methods for smoothing the surface 3a; by way of example, the surface 3a can be mechanically polished. After the conclusion of the smoothing step, the surface 3a of the glass plate 3 is substantially planar, that is to say that it has only low surface roughness or undulation.

This is advantageous in order to ensure that, in a subsequent step, the second component 2 can be wrung onto the smoothed surface 3a of the glass plate 3 (cf. Figure 2b). Since the glass plate 3 is substantially free of deformations or of mechanical stresses, after wringing the stresses cannot result in an undesirable deformation of the surface 3a of the glass plate 3 that destabilizes the connection. In this way, a composite structure 5 arises in which the second, less stiff component 2 is substantially free of deformations, as can be discerned on the right-hand side in Figure 2b.

The wringing can be preceded by a cleaning step in which the surface 3a of the glass plate 3 and the surface 2a of the second component 2 can, for example, be rubbed with buckskin or cleaned with acetone in order to minimize the number of particles on these surfaces. The wringing itself can, if appropriate, be supported with a liquid, for example with polydimethylsiloxane.

In the present exemplary embodiment, the first component 1 is a so-called wafer table, on the top side 1a of which a wafer 6 is mounted. The second component 2 is a so-called wafer chuck, on which a mirror 7 is laterally mounted, e.g. in the form of a reflective coating. The mirror 7 can be irradiated by a laser (not shown) in order to determine the exact position of the wafer chuck or of the composite structure 5. The composite structure 5 positioned in this way can be used in a projection exposure apparatus (not shown) for microlithography, which can be operated at an operating wavelength in the UV wavelength range or in the EUV wavelength range (between approximately 5 nm and approximately 20 nm). By virtue of the wafer chuck 2 exhibiting low deformation, in this case the overlay of the exposure apparatus can be improved, that is to say that the composite structure 5 and thus the wafer 6 can be positioned exactly at the same location during two successive exposure steps.

It goes without saying that the above-described method for producing a composite structure exhibiting low deformation is not restricted to devices for mounting wafers, but rather can also be used advantageously in other cases in which there are components having different stiffnesses (typically where E1 > 2 E2 or > 4 E2), not in accordance with the invention.

By way of example, the second component 2 can be embodied as an EUV mirror and the first component 1 can serve as a carrier for the EUV mirror. Such a component 2 embodied as an EUV mirror generally has a substrate 8 composed of a zero expansion material, e.g. composed of Zerodur® or composed of ULE®, to which a reflective multilayer coating 9 is applied, cf. **Figures 3a****,b.** If the wavelength to be reflected is in the EUV range of between 5 nm and 30 nm, the reflective coating 9 typically comprises individual layers 9a, 9b, which alternately consist of materials having different refractive indices. If the wavelength is approximately 13.5 nm, then the individual layers usually consist of molybdenum and silicon. Other material combinations such as e.g. molybdenum and beryllium, ruthenium and beryllium or lanthanum and B₄C are likewise possible. In addition to the individual layers described, the reflective coating 9 can also comprise intermediate layers for preventing diffusion. The illustration of such auxiliary layers has been omitted.

The first component 1, which serves as a carrier for the second component 2, can be formed from SiSiC as in Figures 2a,b. In particular, cooling channels (not shown) can be introduced into the first component 1, such that the first component 1 can also perform a cooling function in addition to the function as a carrier. In the present example it is of advantage to produce a permanent connection between the glass plate 3 and the EUV mirror 2 instead of a releasable connection by wringing as shown in connection with Figures 2a,b.

A permanent connection can be effected by anodic bonding, for example, which is not illustrated in specific detail in Figures 3a,b. During anodic bonding, a voltage is applied between the components 1, 2, said voltage bringing about charge transport (typically of e.g. alkali metal ions present in the glass plate 3) that promotes a chemical reaction of the silicon atoms at the surface 3a of the glass plate 3 with the aluminum atoms at the aluminum-coated surface 2a - facing away from the coating 9 - of the substrate 8 of the second component 2, such that permanent Si-O-AI bonds are formed at the surfaces 2a, 3a, to be connected, without the two components 1, 2 having to be heated to excessively high temperatures (e.g. temperatures above 450°C). It goes without saying that a permanent connection exhibiting low deformation between the components 1, 2 can, if appropriate, also be produced in a different way, for example by fusion bonding, if the temperatures used in this case are not excessively high.

## Claims

1. Method for joining two components (1, 2) having different stiffnesses (E1, E2) to form a holding device (5) for a wafer, comprising:
bonding a plate-shaped body (3) onto the component (1) having greater stiffness (E1), the bonding being performed using an adhesive,
correcting deformations produced by the bonding on the plate-shaped body (3), and
joining the component (2) having the lower stiffness (E2) to the plate-shaped body (3) without using a joining agent.

2. Method according to Claim 1, wherein the component (2) having the lower stiffness (E2) is joined to the plate-shaped body (3) by wringing, by anodic bonding or by fusion bonding.

3. Method according to Claim 2, wherein the wringing is preceded by a cleaning step and/or the wringing is supported with a liquid.

4. Method according to any of the preceding claims, wherein the plate-shaped body (3) is formed from glass and is preferably subjected to heat treatment after the bonding in order to reduce mechanical stresses.

5. Method according to any of the preceding claims, wherein, before correcting the deformations on the plate-like body (3), there is a wait until the mechanical stresses produced on the plate-shaped body (3) by the bonding no longer change.

6. Method according to any of the preceding claims, wherein there is a wait lasting for at least one week between bonding the plate-like body (3) and correcting the deformations on the plate-shaped body (3).

7. Method according to any of the preceding claims, wherein correcting comprises smoothing a surface (3a) of the plate-shaped body (3) which is connected to the second component (2).

8. Method according to any of the preceding claims, wherein the component (1) having the greater stiffness (E1) contains silicon carbide, and in particular is formed from SiSiC, at least in the region of the connection to the plate-shaped body (3).

9. Method according to any of the preceding claims, wherein the component (2) having the lower stiffness (E2) is formed from cordierite, a glass ceramic, quartz glass or a doped silicate glass, at least in the region of the connection to the plate-shaped body (3).

10. Holding device (5) for a wafer, comprising:
two components (1, 2) having different stiffnesses (E1, E2), and a plate-shaped body (3) bonded onto the component (1) having the greater stiffness (E1) using an adhesive, wherein the component (2) having the lower stiffness (E2) is joined to a surface (3a) of the plate-shaped body (3) without using a joining agent.

11. Holding device according to Claim 10, wherein the plate-shaped body (3) is a glass plate.

12. Holding device according to Claim 10 or 11, wherein the stiffness (E1) of the component (1) having the greater stiffness (E1) is at least double the magnitude of the stiffness (E2) of the component (2) having the lower stiffness (E2).

13. Holding device according to any of Claims 10 to 12, wherein the first component (1) consists of a material which contains silicon carbide, in particular of SiSiC, at least in the region of the connection to the plate-shaped body (3).

14. Holding device according to any of Claims 10 to 13, wherein the second component (2) consists of a material which is selected from the group comprising: cordierite, quartz glass, glass ceramic or doped silicate glass, at least in the region of the connection to the plate-shaped body (3).

## Patentansprüche

1. Verfahren zum Verbinden von zwei Komponenten (1, 2), die unterschiedliche Steifigkeiten (E1, E2) aufweisen, um eine Haltevorrichtung (5) für einen Wafer zu bilden, wobei das Verfahren umfasst:
Bonden eines plattenförmigen Körpers (3) auf die Komponente (1), welche die größere Steifigkeit (E1) aufweist, wobei das Bonden mithilfe eines Klebstoffs ausgeführt wird,
Korrigieren von Verformungen, die durch das Bonden an dem plattenförmigen Körper (3) erzeugt werden, und
Verbinden der Komponente (2), welche die geringere Steifigkeit (E2) aufweist, mit dem plattenförmigen Körper (3), ohne ein Verbindungsmittel zu verwenden.

2. Verfahren nach Anspruch 1, wobei die Komponente (2), welche die geringere Steifigkeit (E2) aufweist, durch ein Ansprengen, durch ein anodisches Bonden oder durch ein Fusionsbonden mit dem plattenförmigen Körper (3) verbunden wird.

3. Verfahren nach Anspruch 2, wobei dem Ansprengen ein Reinigungsschritt vorausgeht und/oder das Ansprengen durch eine Flüssigkeit unterstützt wird.

4. Verfahren nach einem der vorhergehenden Ansprüche, wobei der plattenförmige Körper (3) aus Glas gebildet wird und nach dem Bonden vorzugsweise einer Wärmebehandlung unterzogen wird, um mechanische Spannungen zu verringern.

5. Verfahren nach einem der vorhergehenden Ansprüche, wobei vor dem Korrigieren der Verformungen an dem plattenförmigen Körper (3) eine Wartezeit erfolgt, bis sich die an dem plattenförmigen Körper (3) durch das Bonden erzeugten mechanischen Spannungen nicht mehr verändern.

6. Verfahren nach einem der vorhergehenden Ansprüche, wobei eine Wartezeit zwischen dem Bonden des plattenförmigen Körpers (3) und dem Korrigieren der Verformungen an dem plattenförmigen Körper (3) mindestens eine Woche dauert.

7. Verfahren nach einem der vorhergehenden Ansprüche, wobei das Korrigieren ein Glätten einer Oberfläche (3a) des plattenförmigen Körpers (3) umfasst, die mit der zweiten Komponente (2) verbunden ist.

8. Verfahren nach einem der vorhergehenden Ansprüche, wobei die Komponente (1), die eine größere Steifigkeit (E1) aufweist, Siliciumcarbid enthält und mindestens in dem Gebiet der Verbindung mit dem plattenförmigen Körper (3) insbesondere aus SiSiC hergestellt ist.

9. Verfahren nach einem der vorhergehenden Ansprüche, wobei die Komponente (2), die eine geringere Steifigkeit (E2) aufweist, mindestens in dem Gebiet der Verbindung mit dem plattenförmigen Körper (3) aus einem Cordierit, einer Glaskeramik, einem Quarzglas oder einem dotierten Silicatglas hergestellt ist.

10. Haltevorrichtung (5) für einen Wafer, umfassend:
zwei Komponenten (1, 2), die unterschiedliche Steifigkeiten (E1, E2) aufweisen, und einen plattenförmigen Körper (3), der mithilfe eines Klebstoffs auf die Komponente (1) gebondet wird, welche die größere Steifigkeit (E1) aufweist, wobei die Komponente (2), welche die geringere Steifigkeit (E2) aufweist, mit einer Oberfläche (3a) des plattenförmigen Körpers (3) verbunden wird, ohne ein Verbindungsmittel zu verwenden.

11. Haltevorrichtung nach Anspruch 10, wobei der plattenförmige Körper (3) eine Glasplatte ist.

12. Haltevorrichtung nach Anspruch 10 oder 11, wobei die Steifigkeit (E1) der Komponente (1), welche die größere Steifigkeit (E1) aufweist, mindestens doppelt so groß wie die Größe der Steifigkeit (E2) der Komponente (2) ist, welche die geringere Steifigkeit (E2) aufweist.

13. Haltevorrichtung nach einem der Ansprüche 10 bis 12, wobei die erste Komponente (1) aus einem Material besteht, das Siliciumcarbid enthält, und mindestens in dem Gebiet der Verbindung mit dem plattenförmigen Körper (3) insbesondere aus SiSiC hergestellt ist.

14. Haltevorrichtung nach einem der Ansprüche 10 bis 13, wobei die zweite Komponente (2) aus einem Material besteht, das mindestens in dem Gebiet der Verbindung mit dem plattenförmigen Körper (3) aus einem Cordierit, einer Glaskeramik, einem Quarzglas oder einem dotierten Silicatglas ausgewählt wird.

## Revendications

1. Procédé d'assemblage de deux composants (1, 2) ayant des rigidités différentes (E1, E2) pour former un dispositif de retenue (5) pour une tranche, comprenant :
le collage d'un corps en forme de plaque (3) sur le composant (1) ayant la rigidité supérieure (E1), le collage étant effectué au moyen d'un adhésif,
la correction de déformations produites par le collage sur le corps en forme de plaque (3), et
l'assemblage du composant (2) ayant la rigidité inférieure (E2) au corps en forme de plaque (3) sans utiliser d'agent d'assemblage.

2. Procédé selon la revendication 1, dans lequel le composant (2) ayant la rigidité inférieure (E2) est assemblé au corps en forme de plaque (3) par accolement, par soudure anodique ou par liaison par fusion.

3. Procédé selon la revendication 2, dans lequel l'accolement est précédé d'une étape de nettoyage et/ou l'accolement est favorisé avec un liquide.

4. Procédé selon l'une quelconque des revendications précédentes, dans lequel le corps en forme de plaque (3) est formé à partir de verre et est de préférence soumis à un traitement thermique après le collage afin de réduire les contraintes mécaniques.

5. Procédé selon l'une quelconque des revendications précédentes, dans lequel, avant la correction des déformations sur le corps en forme de plaque (3), on attend jusqu'à ce que les contraintes mécaniques produites sur le corps en forme de plaque (3) par le collage n'évoluent plus.

6. Procédé selon l'une quelconque des revendications précédentes, dans lequel on attend pendant au moins une semaine entre le collage du corps en forme de plaque (3) et la correction des déformations sur le corps en forme de plaque (3).

7. Procédé selon l'une quelconque des revendications précédentes, dans lequel la correction comprend le lissage d'une surface (3a) du corps en forme de plaque (3) qui est reliée au deuxième composant (2).

8. Procédé selon l'une quelconque des revendications précédentes, dans lequel le composant (1) ayant la rigidité supérieure (E1) contient du carbure de silicium, et en particulier est formé à partir de SiSiC, au moins dans la région de la jonction avec le corps en forme de plaque (3).

9. Procédé selon l'une quelconque des revendications précédentes, dans lequel le composant (2) ayant la rigidité inférieure (E2) est formé à partir de cordiérite, d'une vitrocéramique, de verre de quartz ou d'un verre de silicate dopé, au moins dans la région de la jonction avec le corps en forme de plaque (3).

10. Dispositif de retenue (5) pour une tranche, comprenant :
deux composants (1, 2) ayant des rigidités différentes (E1, E2), et un corps en forme de plaque (3) collé sur le composant (1) ayant la rigidité supérieure (E1) au moyen d'un adhésif, le composant (2) ayant la rigidité inférieure (E2) étant assemblé à une surface (3a) du corps en forme de plaque (3) sans utiliser d'agent d'assemblage.

11. Dispositif de retenue selon la revendication 10, dans lequel le corps en forme de plaque (3) est une plaque de verre.

12. Dispositif de retenue selon la revendication 10 ou 11, dans lequel la rigidité (E1) du composant (1) ayant la rigidité supérieure (E1) représente au moins le double de l'amplitude de la rigidité (E2) du composant (2) ayant la rigidité inférieure (E2).

13. Dispositif de retenue selon l'une quelconque des revendications 10 à 12, dans lequel le premier composant (1) consiste en un matériau qui contient du carbure de silicium, en particulier du SiSiC, au moins dans la région de la jonction avec le corps en forme de plaque (3).

14. Dispositif de retenue selon l'une quelconque des revendications 10 à 13, dans lequel le deuxième composant (2) consiste en un matériau qui est choisi dans le groupe comprenant : la cordiérite, le verre de quartz, une vitrocéramique ou du verre de silicate dopé, au moins dans la région de la jonction avec le corps en forme de plaque (3).
